# EUROPEAN PATENT APPLICATION

(11) **EP 4 608 097 A1**
(43) Date of publication of application: **27.08.2025**
(21) Application number: 24198434.3
(22) Date of filing: 04.09.2024
(51) Int. Cl.: H10F 30/221, H10F 39/90, H10F 71/00, H10F 77/14, H01L 25/04, H10F 55/20, H10F 55/255

(54) **PHOTOSENSITIVE CHIP, MANUFACTURING METHOD THEREOF AND PHOTOSENSITIVE MODULE**

(30) Priority: 21.02.2024 TW 113106229
(71) Applicant: Taiwan-Asia Semiconductor Corporation, Hsinchu City 30078 (TW)
(72) Inventor: Hung, Chuan-Yu, 30078 Hsinchu City (TW)
(74) Representative: Michalski Hüttermann & Partner Patentanwälte mbB

(57) **Abstract**

A photosensitive chip, a manufacturing method thereof, and a photosensitive module are provided. The photosensitive chip includes an isosceles trapezoid body, a positive electrode, and a negative electrode. The isosceles trapezoid body comprises an N-type semiconductor layer and a P-type semiconductor layer. The P-type semiconductor layer is disposed adjacent to the N-type semiconductor layer. The positive electrode is electrically connected to the P-type semiconductor layer, and the negative electrode is electrically connected to the N-type semiconductor layer.

## Description

### BACKGROUND OF THE INVENTION

### Field of the Invention

The present invention relates to a photosensitive chip, a manufacturing method thereof, and a photosensitive module, particularly to a photosensitive chip, a manufacturing method thereof, and a photosensitive module that can increase the photosensitive area and is easy to produce.

### Descriptions of the Related Art

A photosensitive chip is a type of optoelectronic conversion device. When light is incident on the photosensitive chip, it can generate corresponding changes in current or voltage. Photosensitive chips are widely used in various optical instruments such as optical communication, optoelectronic detection, automatic brightness adjustment, spectrum analysis, photosensitive circuits, photodetectors, cameras, etc. They are typically used to detect light intensity, measure spectra, or detect light signals.

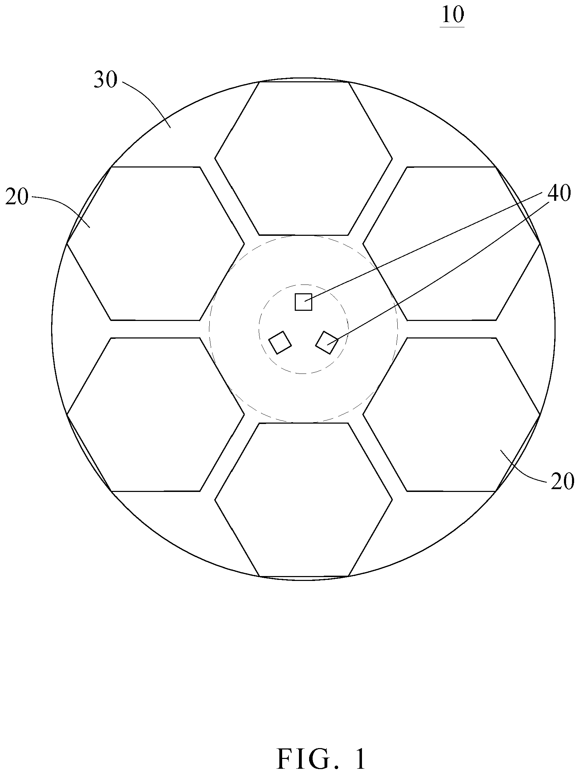

The performance of photosensitive chips is influenced by various factors, including materials, structures, manufacturing processes, and spectral characteristics. Please refer to FIG. 1, which shows a photosensitive module 10 used in known wearable devices. The photosensitive module 10 consists of six photosensitive chips 20, each with a hexagonal outer shape, arranged in a ring. Proper spacing is provided between adjacent chips for the manufacturing process so that the area coverage of the photosensitive chips 20 on a conductive circuit board 30 inside the wearable device can be maximized. In this known photosensitive module 10, most of the light-emitting chips 40 emit light upwards, which is diffusely reflected from the surface of the obj ect under test back to the photosensitive chips 20, where it is absorbed and converted into electronic signals. This known light-emitting photosensitive module can be applied, for example, in smartwatches to provide users with immediate physiological signals.

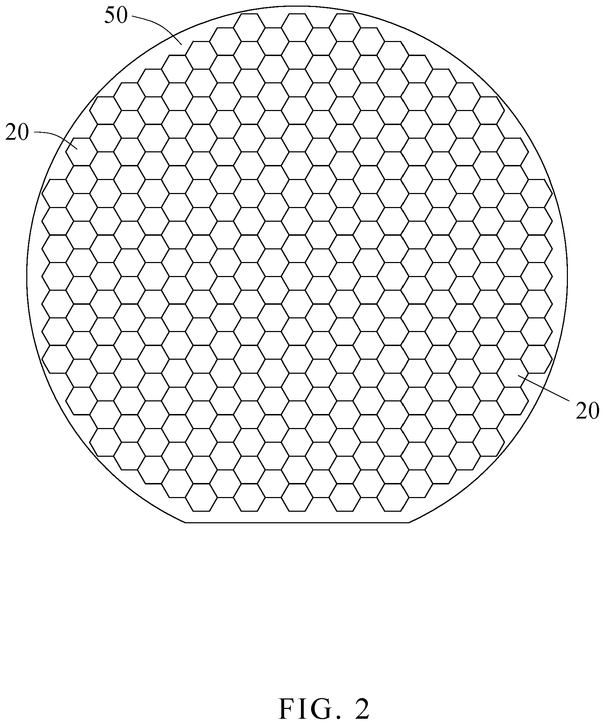

Please refer to FIG. 2, which shows the layout of hexagonal photosensitive chips 20 on a wafer 50 in the known art. Due to their polygonal shape, the outlines of the chips cannot be connected by long straight lines. Therefore, traditional low-cost dicing blade methods and conventional cleaving processes after drawing lines with laser light are not applicable to the wafer singulation after the chip manufacturing process is completed. Instead, only plasma etching processes can be used for singulation. However, applying plasma etching processes on wafers with thicknesses of 100 to 300 micrometers (µm) results in high costs, time consumption, and low product yield rates, all of which need improvement.

### SUMMARY OF THE INVENTION

The objective of the present invention is to provide an innovative photosensitive chip, a manufacturing method thereof, and a photosensitive module. The photosensitive chip features an isosceles trapezoid body, which can be provided by cutting wafers with the traditional straight cutting processes, replacing the current plasma etching process that consumes a large amount of etching materials and requires long processing times. Furthermore, the photosensitive module employing the photosensitive chip has advantages such as a larger light-receiving area, resulting in power saving, and design flexibility to adjust the area size according to requirements, particularly beneficial for applications in smart wearable devices.

To achieve the above objective, the present invention provides a photosensitive chip comprising an isosceles trapezoid body, a positive electrode, and a negative electrode. The isosceles trapezoid body includes an N-type semiconductor layer and a P-type semiconductor layer, with the P-type semiconductor layer adjacent to the N-type semiconductor layer. The positive electrode is electrically connected to the P-type semiconductor layer, and the negative electrode is electrically connected to the N-type semiconductor layer.

In one embodiment of the photosensitive chip of the present invention, the included angle between one of two non-parallel sides and a long side of two parallel sides of the isosceles trapezoid body ranges from 50° to 70°.

In one embodiment of the photosensitive chip of the present invention, the included angle is 60°.

In one embodiment of the photosensitive chip of the present invention, the height of the isosceles trapezoid body ranges from 0.87 to 5.22 times the length of the short side of the two parallel sides.

In one embodiment of the photosensitive chip of the present invention, the height of the isosceles trapezoid body is 1.44 times the length of the short side of the two parallel sides.

In one embodiment of the photosensitive chip of the present invention, the photosensitive chip is a silicon-based photosensitive chip.

In one embodiment of the photosensitive chip of the present invention, the photosensitive chip is one of a photodiode and a phototransistor.

In one embodiment of the photosensitive chip of the present invention, the positive electrode and the negative electrode are disposed on two opposite sides of the isosceles trapezoid body.

In one embodiment of the photosensitive chip of the present invention, the positive electrode and the negative electrode are disposed on the same side of the isosceles trapezoid body.

In one embodiment of the photosensitive chip of the present invention, the P-type semiconductor layer is disposed on the N-type semiconductor layer, or the N-type semiconductor layer is disposed on the P-type semiconductor layer.

To achieve the above objective, the present invention provides a method for manufacturing a photosensitive chip, comprising the following steps: providing a wafer; straight cutting the wafer to form a plurality of first dicing lines parallel to each other; straight cutting the wafer to form a plurality of second dicing lines parallel to each other and into a plurality of parallelogram units; and singulating the parallelogram units to form a plurality of isosceles trapezoid bodies as described above.

In one embodiment of the method for manufacturing a photosensitive chip of the present invention, before the step of singulating the parallelogram units, further comprising a step of re-arranging the parallelogram units such that central lines of each adjacent upper and lower parallelogram units are aligned and connected into a plurality of pre-cutting lines, wherein each of the central lines of the parallelogram units divides each of the parallelogram units into two isosceles trapezoid bodies invertedly connected to each other.

In one embodiment of the method for manufacturing a photosensitive chip of the present invention, the step of singulating the parallelogram units is performed by cutting along the plurality of pre-cutting lines with a dicing blade.

In one embodiment of the method for manufacturing a photosensitive chip of the present invention, the steps of straight cutting the wafer are performed by cutting with a dicing blade.

In one embodiment of the method for manufacturing a photosensitive chip of the present invention, the step of singulating the parallelogram units is performed by laser dicing.

To achieve the above objectives, the present invention provides a photosensitive module comprising: a conductive circuit board and six photosensitive chips as described above. The conductive circuit board has a central portion and a peripheral portion, wherein the peripheral portion surrounds the central portion. Each of the photosensitive chips is arranged around the peripheral portion, and each of the photosensitive chips is spaced approximately 60° apart.

In one embodiment of the photosensitive module of the present invention, the photosensitive module further comprises at least one active chip disposed in the central portion.

In one embodiment of the photosensitive module of the present invention, the active chip is a light-emitting chip for emitting light of at least one wavelength, wherein the light is diffusely reflected from a surface of an obj ect under test back to the photosensitive chips, absorbed by the photosensitive chips, and converted into an electronic signal.

In one embodiment of the photosensitive module of the present invention, the light-emitting chip is selected from a group comprising green light-emitting diodes, red light-emitting diodes, short-wave infrared light-emitting diodes, long-wave infrared light-emitting diodes, and combinations thereof.

In one embodiment of the photosensitive module of the present invention, a height of each of the isosceles trapezoid bodies is adjustable to vary an area of each photosensitive chip.

In one embodiment of the photosensitive module of the present invention, there is a distance between each two adjacent photosensitive chips.

In one embodiment of the photosensitive module of the present invention, the distance is approximately 20 mils.

After referring to the drawings and the embodiments as described in the following, those having ordinary skill in the art can understand other objectives of the present invention, as well as the technical means and embodiments of the present invention.

### BRIEF DESCRIPTION OF THE DRAWINGS

FIG. 1 is a schematic diagram illustrating the application of a known photosensitive module in a wearable device;
FIG. 2 is a schematic diagram illustrating the layout of a conventional wafer with photosensitive chips having a hexagonal shape;
FIG. 3A is a top view schematic diagram of a photosensitive chip in an embodiment of the present invention;
FIG. 3B is a side view schematic diagram of a photosensitive chip in an embodiment of the present invention;
FIG. 4 is a schematic diagram illustrating the layout of a wafer with photosensitive chips having an isosceles trapezoid shape before being singulated in an embodiment of the present invention;
FIG. 5A is a schematic diagram illustrating the removal of incomplete peripheral chips from the wafer after cutting the wafer in an embodiment of the present invention as shown in FIG. 4;
FIG. 5B is a schematic diagram illustrating the rearrangement of parallelogram units after cutting the wafer in an embodiment of the present invention;
FIG. 6 is a schematic diagram illustrating a photosensitive module in an embodiment of the present invention; and
FIG. 7 is a comparative schematic diagram illustrating a comparison between a photosensitive module of the present invention and a conventional photosensitive module.

### DETAILED DESCRIPTION OF THE PREFERRED EMBODIMENT

In the following description, the present invention will be explained with reference to various embodiments thereof. These embodiments of the present invention are not intended to limit the present invention to any specific environment, application, or particular method for implementations described in these embodiments. Therefore, the description of these embodiments is for illustrative purposes only and is not intended to limit the present invention. It shall be appreciated that, in the following embodiments and the attached drawings, a part of elements not directly related to the present invention may be omitted from the illustration, and dimensional proportions among individual elements and the numbers of each element in the accompanying drawings are provided only for ease of understanding but not to limit the present invention.

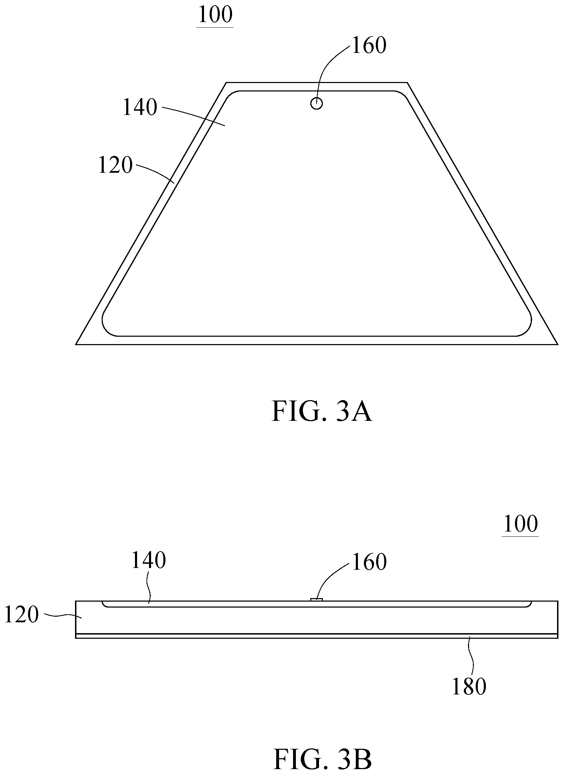

Please refer to FIGs. 3A and 3B, where FIG. 3A shows a top view schematic of a photosensitive chip 100 in an embodiment of the present invention, and FIG. 3B shows a side view schematic of the photosensitive chip 100 of the present invention. In terms of its appearance, the photosensitive chip 100 has an isosceles trapezoid body, where the lengths of the two non-parallel sides of the trapezoid body are substantially equal, and the included angle between one of the two non-parallel sides and a long side of the two parallel sides is between 50° and 70°, preferably 60°. Additionally, the height of the isosceles trapezoid body is between 0.87 and 5.22 times the length of the shorter side of the two parallel sides, preferably 1.44 times. In a preferred embodiment, the height of the isosceles trapezoid body is approximately 144 mils, the length of the shorter side of the two parallel sides is approximately 100 mils, the length of the longer side of the two parallel sides is approximately 267 mils, and the thickness is approximately 8 mils.

Continuing to refer to FIGs. 3A and 3B, in terms of functionality, the photosensitive chip 100 has an isosceles trapezoid body, which includes an N-type semiconductor layer 120 and a P-type semiconductor layer 140. The photosensitive chip 100 further includes a positive electrode 160 and a negative electrode 180. The P-type semiconductor layer 140 is a P-type semiconductor diffusion layer, and the N-type semiconductor layer 120 is a substrate layer. Moreover, the P-type semiconductor layer 140 is adjacent to the N-type semiconductor layer 120, the positive electrode 160 is electrically connected to the P-type semiconductor layer 140, and the negative electrode 180 is electrically connected to the N-type semiconductor layer 120. Furthermore, the photosensitive chip 100 can be in the form of a chip with wire bonding connecting the positive electrode, i.e., the positive electrode 160 and the negative electrode 180 can be disposed on opposite sides of the N-type semiconductor layer 120 (isosceles trapezoid body), as shown in FIG. 3B, but not limited to this configuration. For example, the photosensitive chip 100 can also be in the form of a chip with flip-chip bonding, where the positive electrode 160 and the negative electrode 180 are both disposed on the same side of the isosceles trapezoid body, i.e., the side of the P-type semiconductor layer 140. The photosensitive chip 100 can be either a photodiode or a photosensitive transistor. For example, the photosensitive chip 100 is a silicon-based photodiode chip that generates photocurrent by absorbing photons, thereby converting them into electronic signals.

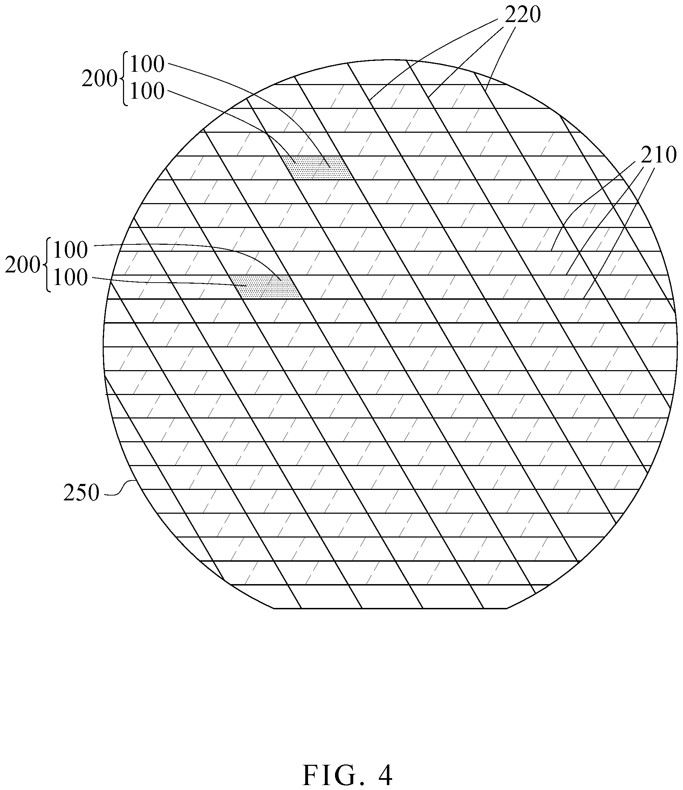

Please refer to FIG. 4, which shows the arrangement layout of the photosensitive chips 100 with the isosceles trapezoid shape before being cut on a wafer 250. The wafer layout shown in FIG. 4 combines the isosceles trapezoid bodies of adjacent photosensitive chips 100 by flipping them upside down to form a parallelogram unit 200, where one of the non-parallel sides of the isosceles trapezoid bodies of adjacent chips overlaps, and the parallel sides of adjacent isosceles trapezoid bodies are connected for allowing the plurality of parallelogram units 200 to be arranged in a parallel and densely connected manner on the wafer 250. Consequently, the parallel sides of each parallelogram unit 200 adjacent to each other horizontally and vertically on the wafer 250 can be connected to form a plurality of parallel first cutting lines 210 and a plurality of parallel second cutting lines 220, which are planned for subsequent cutting.

The method of manufacturing photosensitive chips of the present invention includes the following steps. After forming semiconductor device structures on the wafer 250 as shown in FIG. 4, the wafer 250 is cut along the parallel sides of the plurality of parallelogram units connected to each other using straight-line cutting. This process thereby forms multiple parallel first cutting lines 210 on the wafer 250. Subsequently, the wafer 250 is cut along the other parallel sides of the multiple parallelogram units connected to each other using straight-line cutting to form multiple parallel second cutting lines 220 on the wafer 250. The resulting wafer 250 will form multiple parallelogram units 200 that can be separated individually. It should be noted that both the first cutting lines 210 and the second cutting lines 220 on the wafer 250 are parallel straight lines. Thus, the two cutting processes can be performed by using low-cost cutting tools.

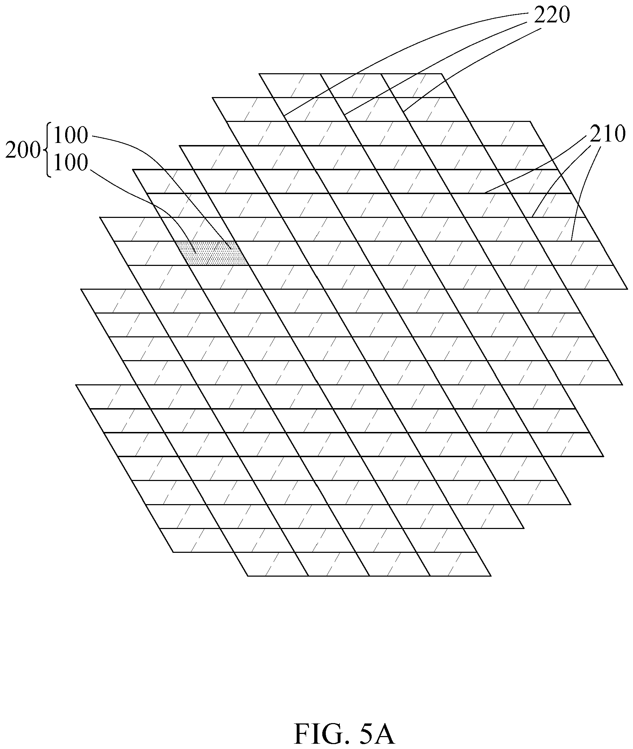

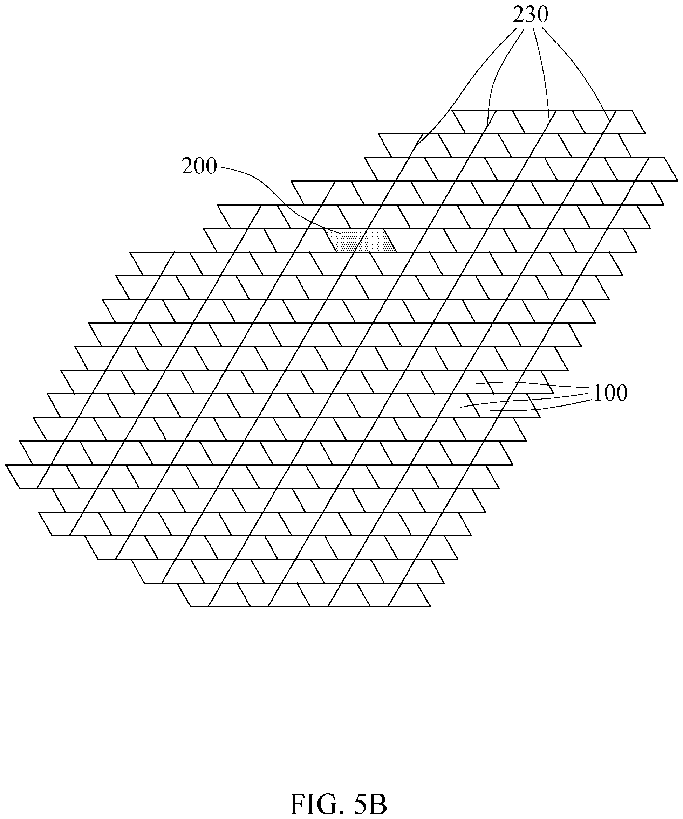

After removing the incomplete chips from the periphery of the wafer, the wafer is cut into a plurality of parallelogram-shaped chips arranged as shown in FIG. 5A can be obtained. Subsequently, horizontal transfer of the parallelogram units can be performed using equipment such as a sorter or a die bonder, and they can be repositioned and fixed on a blue tape. The arrangement of these parallelogram units involves aligning and connecting the central lines of adjacent upper and lower parallelogram units to form a plurality of pre-cutting lines 230, as shown in FIG. 5B. The central line of each parallelogram unit is formed by overlapping one of non-parallel sides of the adjacent inverted isosceles trapezoidal bodies in each parallelogram unit. In other words, the central line of each parallelogram unit can effectively divide each parallelogram unit into two inverted trapezoidal bodies. Then, the blue tape is cut along the plurality of pre-cutting lines 230 to form a plurality of isosceles trapezoidal bodies as described above, thereby forming the photosensitive chips 100 of the present invention. As shown in FIG. 5B, since the pre-cutting lines 230 are long straight lines formed by aligning and connecting the central lines of adjacent upper and lower parallelogram units, they can be cut using traditional cutting tools. Compared to the conventional method of using special plasma etching for separating chips with special shapes, the present invention allows chip cutting using conventional cutting tools. This not only significantly reduces process time and cost but also improves process yield, overcoming various process issues associated with the conventional techniques mentioned above.

It should be noted that, in addition to the above whole cutting process, after obtaining the parallelogram chips arranged as shown in FIG. 5A, the central line of the aforementioned parallelogram units (i.e., the non-parallel side overlapped among the trapezoidal bodies) can also be completed by laser cutting, that is, the chips are split after applying the laser beam. Compared to the conventional technique of dividing wafers using plasma etching, both of these wafer separation processes can significantly save production costs and processing time without the need to purchase expensive plasma etching equipment and large amounts of etching materials.

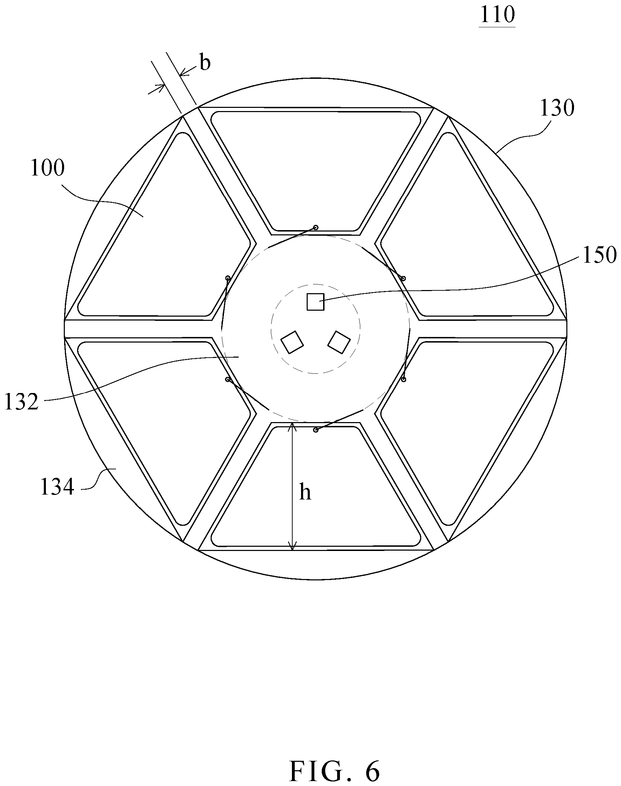

Please refer to FIG. 6, which shows the photosensitive module 110 of the present invention. The photosensitive module 110 includes a conductive circuit board 130, at least one active chip 150, and six photosensitive chips 100 as described above. The conductive circuit board 130 has a central portion 132 and an outer peripheral portion 134 surrounding the central portion 132. Specifically, the conductive circuit board 130 is a substantially circular printed circuit board (PCB) with a diameter of, for example, 568 mils. The central portion 132 of the conductive circuit board 130 is a bonding area for the light-emitting chip and is used to accommodate at least one active chip 150, which serves as an active element for emitting light or signals in smart wearable devices. In this embodiment, the active chip 150 is a light-emitting chip that emits light of at least one wavelength, which is diffusely reflected from the surface of an object under test back into the photosensitive chips 100, where it is absorbed and converted into an electronic signal. Specifically, the active chip 150 can be selected from a group comprising light-emitting diode chips that are 20 mils in size and emitting green light with a wavelength of 495-570 nanometers (nm), emitting red light with a wavelength of 620-750 nm, and emitting infrared light with a wavelength of 940 nm, and combinations thereof.

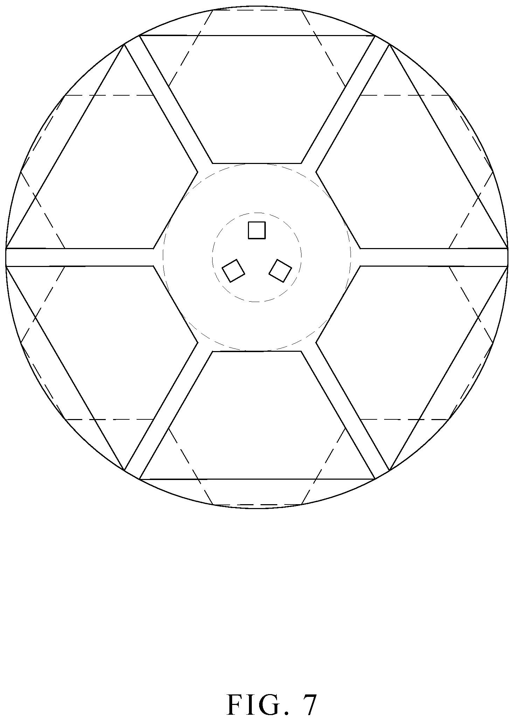

The outer peripheral portion 134 of the conductive circuit board 130 serves as a bonding area for photosensitive chips. In this embodiment, six photosensitive chips 100, each having a trapezoidal shape as shown in FIG. 3, are respectively bonded to the outer peripheral portion 134. These six trapezoidal photosensitive chips are arranged around the outer peripheral portion 134, with each chip spaced approximately 60° apart from each other. Specifically, please refer to FIG. 6, where the trapezoidal bodies of each photosensitive chip 100 are oriented with their short sides facing towards the central portion 132, and each chip is rotated relative to the adjacent chip by 60°, with distance b between adjacent chips required by the manufacturing process. This distance b can be, but is not limited to, 20 mils, allowing the chip area to be maximally filled in the outer peripheral portion 134 of the conductive circuit board 130. Compared to the photosensitive modules comprising hexagonal chips in the conventional techniques, under the same diameter of the conductive circuit board, the total light-receiving area of the photosensitive chips in the present invention's photosensitive module can increase by approximately 2%, as shown in FIG. 7. For wearable devices, a larger light-receiving area means reducing more power consumption. Therefore, in addition to the advantages of cost saving and yield improvement of the photosensitive chips mentioned above, the photosensitive module of the present invention also has advantages such as power saving and performance improvement.

It should be noted that, as shown in FIG. 6, another feature of the photosensitive module 110 of the present invention is that the height h of the trapezoidal bodies of each photosensitive chip 100 can be adjusted and changed according to actual requirements to adjust the area of each photosensitive chip. This feature increases the flexibility of the photosensitive module in actual application design. In contrast, the hexagonal chips in conventional techniques do not have the characteristic of adjustable areas for chip size. Specifically, in the photosensitive module 110 of the present invention, the height of the photosensitive chip is essentially between 0.87 and 5.22 times the length of its short parallel side, and the angle between the non-parallel side and the long parallel side is between 50 and 70 degrees, which are all within the implementation range capable of achieving high light-receiving efficiency.

Additionally, it is to be noted that the conductive circuit board of the photosensitive module of the present invention also includes a set of conductive circuits (not shown) and an insulating substrate for carrying circuits (the same size as the conductive circuit board). The conductive circuit board has double-sided circuits (i.e., conductive circuits on opposite sides of the insulating substrate) that are interconnected, with most of the circuits disposed on the opposite side of the active chip and the photosensitive chip, to electrically connect the electrodes of the active chip and the six photosensitive chips in the module to the conductive circuit board and then to the outside of the conductive circuit board (not shown). Furthermore, the insulating substrate is substantially circular and carries the aforementioned conductive circuits, can be accommodated in a wearable device, and can be used to fix the photosensitive module to the wearable device.

The above embodiments are used only to illustrate the implementations of the present invention and to explain the technical features of the present invention and are not used to limit the scope of the present invention. Any modifications or equivalent arrangements that can be easily accomplished by people skilled in the art are considered to fall within the scope of the present invention, and the scope of the present invention should be limited by the claims of the patent application.

## Claims

1. A photosensitive chip, comprising:
an isosceles trapezoid body, comprising:
an N-type semiconductor layer;
a P-type semiconductor layer, disposed adjacent to the N-type semiconductor layer;
a positive electrode, electrically connected to the P-type semiconductor layer; and
a negative electrode, electrically connected to the N-type semiconductor layer.

2. The photosensitive chip of the previous claim, wherein the isosceles trapezoid body has an included angle between one of two non-parallel sides and a long side of two parallel sides of the isosceles trapezoid body, and the included angle ranges from 50° to 70°, and wherein preferably the included angle is 60°.

3. The photosensitive chip of any of the previous claims, wherein a height of the isosceles trapezoid body ranges from 0.87 to 5.22 times a length of a short side of the two parallel sides, and wherein preferably the height of the isosceles trapezoid body is 1.44 times the length of the short side of the two parallel sides.

4. The photosensitive chip of any of the previous claims, wherein the photosensitive chip is a silicon-based photosensitive chip, and/or wherein the photosensitive chip is one of a photodiode and a phototransistor.

5. The photosensitive chip of any of the previous claims, wherein the positive electrode and the negative electrode are disposed on two opposite sides of the isosceles trapezoid body, or wherein the positive electrode and the negative electrode are disposed on the same side of the isosceles trapezoid body.

6. The photosensitive chip of any of the previous claims, wherein the P-type semiconductor layer is disposed on the N-type semiconductor layer, or the N-type semiconductor layer is disposed on the P-type semiconductor layer.

7. A method for manufacturing a photosensitive chip, comprising:
providing a wafer;
straight cutting the wafer to form a plurality of first dicing lines parallel to each other;
straight cutting the wafer to form a plurality of second dicing lines parallel to each other and into a plurality of parallelogram units; and
singulating the parallelogram units to form a plurality of isosceles trapezoid bodies as claimed in any of the previous claims.

8. The method for manufacturing a photosensitive chip of the previous claim, before the step of singulating the parallelogram units, further comprising re-arranging the parallelogram units such that central lines of each adjacent upper and lower parallelogram units are aligned and connected into a plurality of pre-cutting lines, wherein each of the central lines of the parallelogram units divides each of the parallelogram units into two isosceles trapezoid bodies invertedly connected to each other.

9. The method for manufacturing a photosensitive chip of the previous claim, wherein the step of singulating the parallelogram units is performed by cutting along the plurality of pre-cutting lines with a dicing blade.

10. The method for manufacturing a photosensitive chip of any of the previous method claims, wherein the steps of straight cutting the wafer are performed by cutting with a dicing blade, and/or wherein the step of singulating the parallelogram units is performed by laser dicing.

11. A photosensitive module, comprising:
a conductive circuit board, having a central portion and a peripheral portion surrounding the central portion; and
six photosensitive chips as claimed in any of the previous photosensitive chip claims, each of the photosensitive chips being arranged around the peripheral portion, and each of the photosensitive chips being spaced approximately 60° apart.

12. The photosensitive module of the previous claim, further comprising at least one active chip disposed in the central portion.

13. The photosensitive module of the previous claim, wherein the at least one active chip is a light-emitting chip for emitting light of at least one wavelength, wherein the light is diffusely reflected from a surface of an object under test back to the photosensitive chips, absorbed by the photosensitive chips, and converted into an electronic signal.

14. The photosensitive module of the previous claim, wherein the light-emitting chip is selected from a group comprising green light-emitting diodes, red light-emitting diodes, short-wave infrared light-emitting diodes, long-wave infrared light-emitting diodes, and combinations thereof.

15. The photosensitive module of any of the previous photosensitive module claims, wherein a height of each of the isosceles trapezoid bodies is adjustable to vary an area of each of the photosensitive chips, and/or wherein there is a distance between each two adjacent photosensitive chips, and wherein preferably the distance is approximately 20 mils.
